# EUROPEAN PATENT APPLICATION

(11) **EP 0 621 632 A1**
(43) Date of publication of application: **26.10.1994**
(21) Application number: 94105556.8
(22) Date of filing: 11.04.1994
(51) Int. Cl.: H01L 21/82, H01L 27/108

(54) **Trench capacitor dram**

(30) Priority: 22.04.1993 US 52330
(71) Applicant: International Business Machines Corporation, Armonk, N.Y. 10504 (US)
(72) Inventor: Rajeevakumar, Thekkemadathil V., Scarsdale, New York 10583 (US); Sanda, Pia Naoko, Chappaqua, New York 10514 (US)
(74) Representative: Schäfer, Wolfgang, Dipl.-Ing.

(57) **Abstract**

A DRAM cell structure comprises a self-aligned surface strap (38) between a trench capacitor (10) and a diffusion region (20) where the strap comprises polysilicon coated with an electrically conductive liner diffusion barrier material (36) in order to prevent diffusion from the strap to an active region of the device. The preferred diffusion barrier materials are TiN and TaN.

## Description

### Background of the Invention

The present invention relates to polysilicon surface straps for use in high density DRAM cells. Specifically, the invention relates to a surface strap which is self-aligned to the wordline of the cell and which has maximum contact area in order to minimize contact resistance. Quite specifically, an electrically conductive self-aligned surface strap includes a liner diffusion barrier material, preferably TiN or TaN, to prevent any dopant from the heavily doped strap, from diffusing into the sensitive device region of the cell.

It is known in the prior art, such as U.S. Patent No. 5,097,381, that titanium silicide straps may be used on the surface of a double sidewall trench capacitor. U.S. Patent No. 5,087,588 describes a DRAM cell having a polysilicon surface strap for bridging the storage node to the device over a dielectric film. U.S. Patent No. 5,065,273 describes a trench DRAM cell including a polycide strap formed by chemical mechanical polishing.

U.S. Patent No. 4,897,709 describes the use of TiN in high aspect ratio holes such as inside a trench where the TiN may be used as a plate.

In U.S. Patent No. 5,010,032 TiN is used as a patterned interconnect structure in CMOS SRAM between n+ polysilicon (silicide) and p+ diffusion (silicide) and between n+ diffusion (silicide) and p+ polysilicon (silicide) in order to prevent diffusion of dopants and thereby prevent the formation of a p-n junction.

U.S. Patent No. 5,001,108 describes a metal-to-superconductor barrier layer of TiN to prevent aluminum from forming an alloy with silicon.

U.S. Patent No. 4,894,693 describes a DRAM cell structure where TiN is used as the top capacitor electrode and polysilicon is used as the bottom capacitor electrode. The TiN is utilized as a conductor as well as a diffusion barrier.

In U.S. Patent No. 4,804,636 TiN is used as a layer between metal and polysilicon.

In European Patent Application No. 91109991 a thin barrier layer of TiN is described for use as an electric connection between a first diffusion region of a MOSFET and the storage electrode region of an associated capacitor.

IBM Technical Disclosure Bulletin, volume 29, no. 3, August 1986 pages 1037 and 1038 discloses titanium silicide bridging of a trench.

IBM Technical Disclosure Bulletin, volume 33, no. 10A, March 1991 at pages 260 to 262 discloses a process of making a shallow trench isolation self-aligned to a storage trench.

### Summary of the Invention

The present invention concerns a DRAM cell structure comprising a self-aligned surface strap between a trench capacitor and a diffusion region The strap comprises polysilicon with an electrically conductive diffusion barrier, preferably with a TiN liner in order to prevent diffusion from the strap to an active region of the device for preserving the integrity of the active device. The invention is particularly useful for scaled down DRAM cells where the high density, close-spaced packaging of the devices renders the devices more susceptible to dopant out diffusion from the strap.

For higher density DRAMs, 256Mb DRAM and above, with a trench capacitor as the storage element, the trench storage node contact to the source/drain is an important technological consideration. A surface strap or a buried (diffusion) strap are the preferred contact technologies.

The present invention describes a fully encapsulated surface strap and design layout having sufficient overlay tolerances. A cell layout similar to a layout used in 64Mb DRAMs has an area of 0.60*µm*², using 0.25*µm* minimum lithography feature size.

Diffusion straps have several disadvantages such as poor control of dopant diffusion due to thermal budget variations. Also any thin insulator layer remaining on the trench sidewall window opened for the strap could prevent the strapping.

The preferred embodiment of the present invention uses a heavily doped polysilicon strap. An electrically conductive diffusion barrier layer or coating prevents the dopants from the polysilicon strap from diffusing into the source/drain or into the active access device area. The preferred layer is TiN or alternatively TaN. Moreover, by locating the layer or coating between the polysilicon strap and source/drain diffusion area, the electrical contact resistance improves. The strap is self-aligned to the wordline, and thus provides a maximum contact area. The strap is also electrically encapsulated from the intrinsic polysilicon mandrel. Either a permanent or removable polysilicon mandrel is useable for the surface strap. A surface strap of the type contemplated by the present invention is fully compatible with existing fabrication methods for diffusion strap.

A principal object of the present invention is therefore, the provision of a polysilicon surface strap, which is self-aligned to the gate of the transfer device and which strap uses an electrically conductive material as a diffusion barrier to prevent any dopants from diffusing into the sensitive device area.

Another object of the present invention is the provision of a self-aligned polysilicon surface strap which uses TiN as a diffusion barrier primarily for use in high density DRAMs.

A further object of the present invention is the provision of a method of fabricating a self-aligned polysilicon surface strap which uses an electrically conductive material as a diffusion barrier.

A still further object of the present invention is the provision of a method of fabricating a self-aligned polysilicon surface strap which uses TiN as a diffusion barrier primarily for use in a high density DRAM.

Further and still other objects of the invention will become more clearly apparent when the following description is read in conjunction with the accompanying drawing.

### Brief Description of the Drawing

Figure 1 is a cross-sectional representation of a DRAM cell comprising a trench, LOCOS/STI and wordline;
Figure 2 is a cross-sectional representation of the DRAM cell in Figure 1 after further processing;
Figure 3 is a cross-sectional representation of the DRAM cell in Figure 2 after further processing;
Figure 4 is a cross-sectional representation of the DRAM cell in Figure 3 after further processing;
Figure 5 is a cross-sectional representation of the DRAM cell in Figure 4 after further processing;
Figure 6 is a cross-sectional representation of the DRAM cell in Figure 5 after further processing;
Figure 7 is a plan view of a layer of the trench storage cell with a surface strap, and
Figure 8 is a magnified cell layout of a portion of the trench storage cell shown in Figure 7.

### Detailed Description

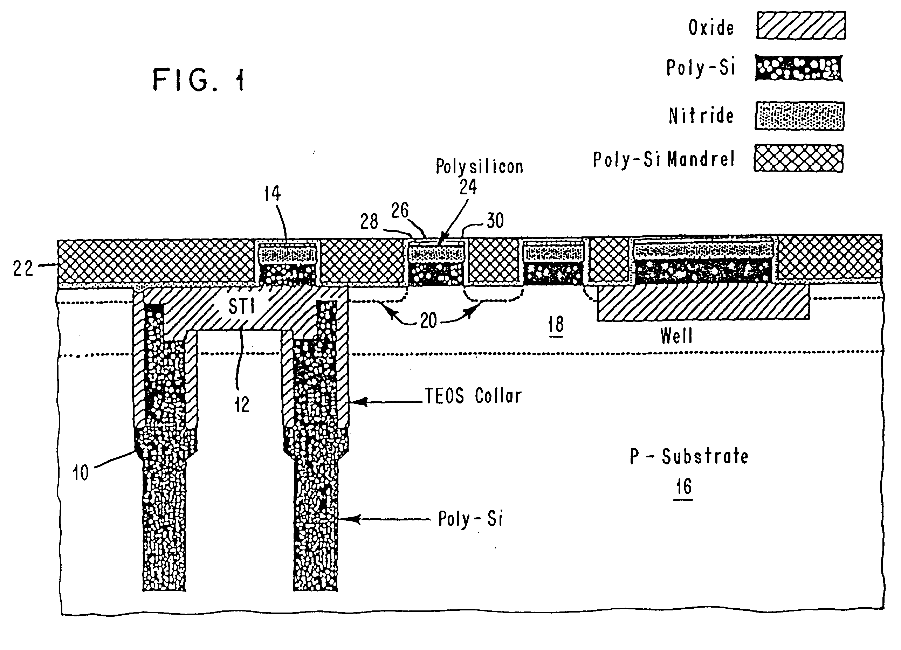

Referring now to the figures and to Figure 1 in particular, there is shown in cross-section a conventional storage trench 10, LOCOS/STI 12 (local oxidation of silicon/shallow trench isolation) and wordline 14 located in p-substrate 16. The trench, LOCOS/STI and wordline are formed in a conventional manner such as is described in Lu et al, "A Substrate Plate Trench Capacitor (SPT) Memory Cell for Dynamic RAMs," IEEE J. of Solid State Circuits, Vol. SC-21, No. 5, pp. 627-633 (1986), which is incorporated herein by reference. Fabrication of a wordline that is vertically disposed relative to an underlying trench and, in particular, to a conductive surface strap that couples the trench capacitor electrode to an access device, referred to as the strap being self-aligned to the wordline, is described in U.S. Patent No. 5,065,273 entitled "High Capacity DRAM Trench Capacitor and Methods of Fabricating Same", the inventor of which patent is a co-inventor of the present invention. This patent is incorporated herein by reference.

A well 18 and source/drain 20 are implanted as shown in Figure 1. An intrinsic polysilicon mandrel 22 is deposited and planarized by polishing. If a tool and process for etching oxide selective to nitride, such as a LAM Model 4500 etcher using *CHF*₃/Ar chemistry, is unavailable, a thin polysilicon layer 24 is introduced at the gate stack 26 sandwiched between two nitride layers 28, 30 for selective etching.

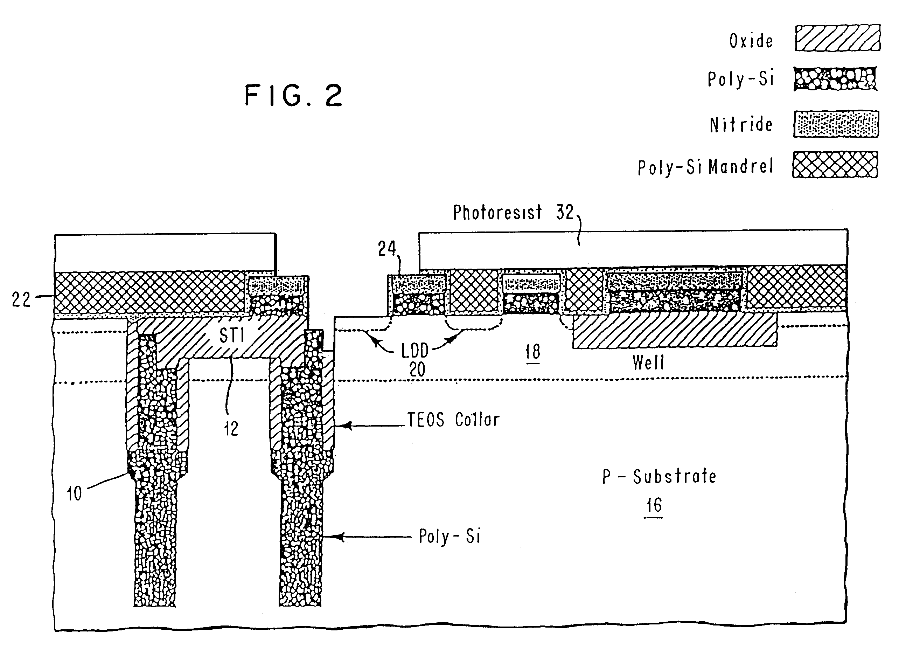

Using a strap mask, intrinsic polysilicon is removed selective to nitride. Then the nitride layer is etched to form spacers and trench cap oxide is etched selective to silicon as shown in Figure 2. Photoresist 32 is stripped and removed.

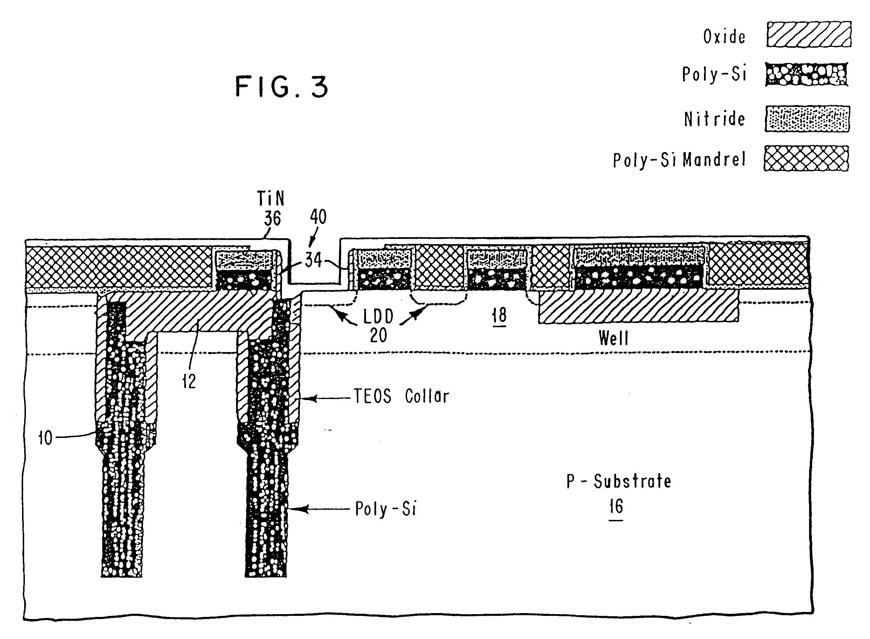

A 30 nm oxide spacer 34 is formed around the strap region 40 as shown in Figure 3. A 40 nm electrically conductive diffusion barrier layer, such as a TiN layer 36, is then blanket deposited over the entire substrate 16.

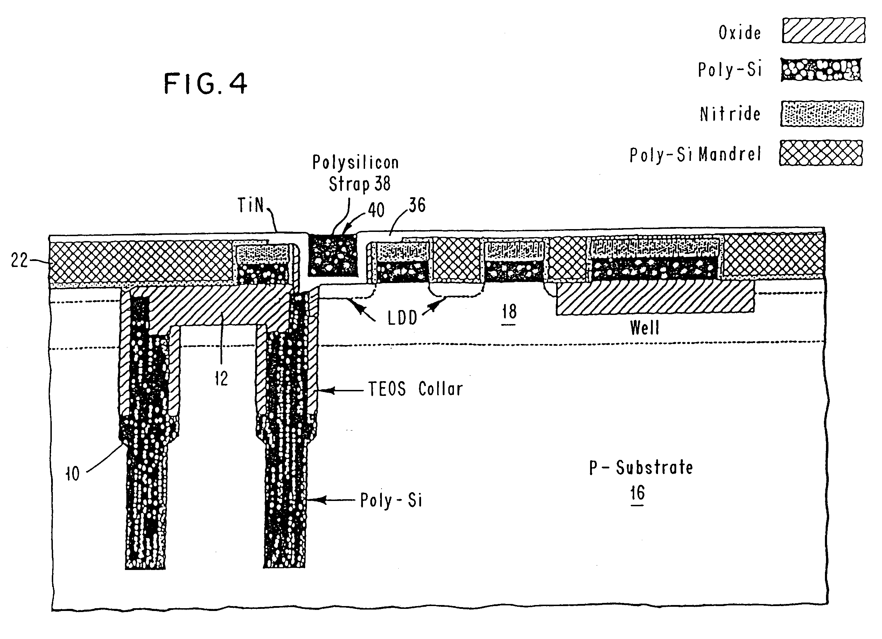

As shown in Figure 4, heavily doped polysilicon 38 is deposited into strap region 40, polished and recessed below the top surface of the TiN layer 36.

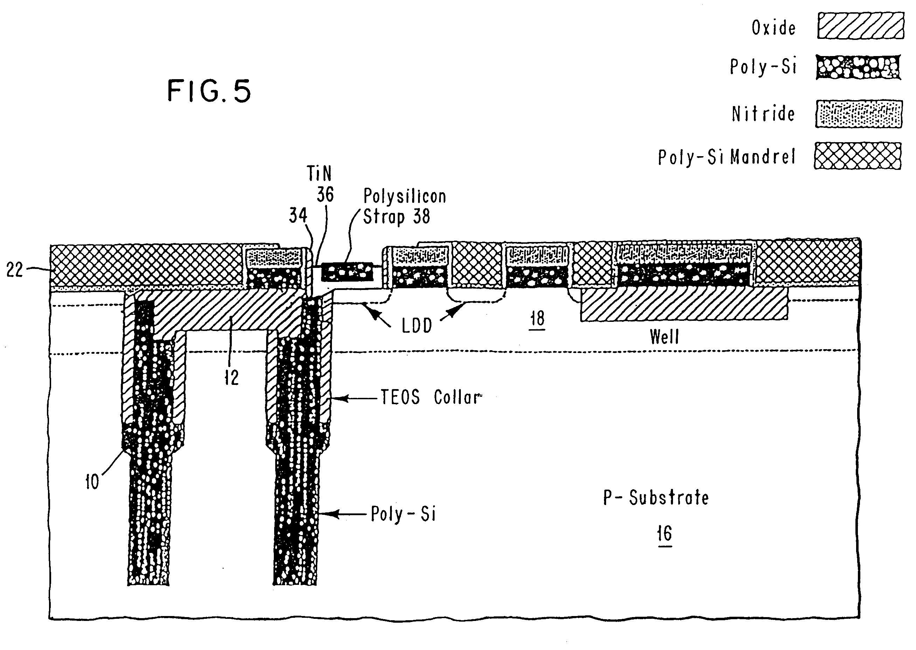

Then the TiN layer 36 is removed from the top of the structure by etching and polysilicon 38 is further recessed as shown in Figure 5. The TiN layer 36 can be dry-etched selective to oxide or nitride using chlorine based chemistry. A thin layer of nitride 28 is removed from the top of the structure. The resultant exposed thin polysilicon layer 24 is also removed as shown in Figure 5.

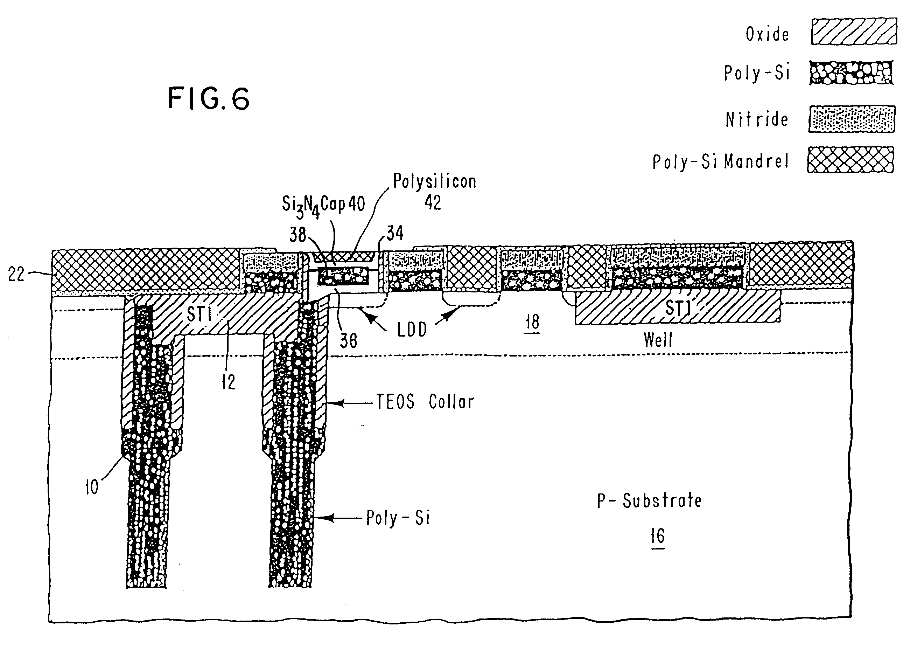

An approximately 30 nm thick silicon nitride cap layer 40, (shown only over strip 38 in Figure 6) is deposited followed by intrinsic polysilicon 42 deposition over the cap layer 40. The polysilicon 42 is planarized by polishing if a plane surface is desired for the metal levels. The cap layer 40 is etched off selective to polysilicon along the top surface of the structure, leaving only the portion between strip 38 and polysilicon 42.

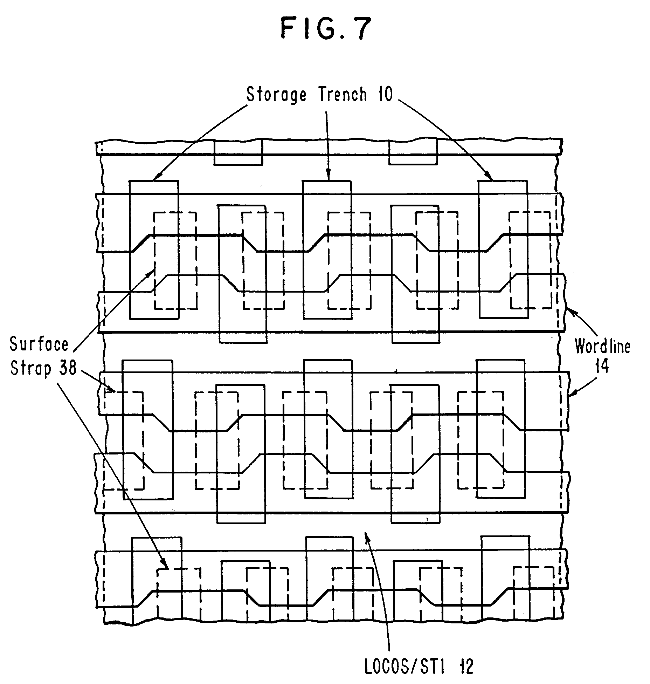

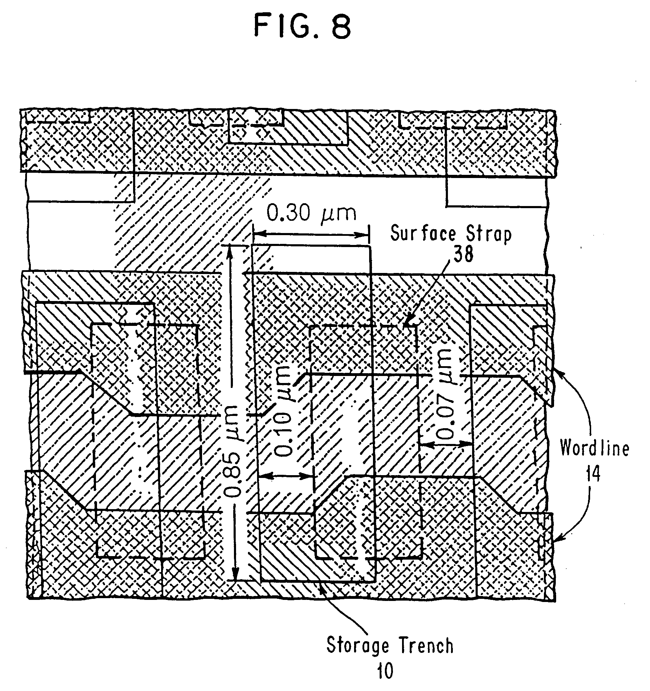

Figure 7 is a plan view of a layout of the trench storage cell with a surface strap. The cell area is 0.6*µm*² and the minimum lithography feature size is 0.25*µm*. The trench dimensions are 0.85*µm* x 0.25*µm*. The worst case alignment tolerance between the surface strap and the trench is assumed to be 0.125*µm*. Figure 8 is a magnified cell layout of a portion of the trench storage cell shown in Figure 7. The spacing considers the trench collar thickness of the surface strap. The trench oxide collar is assumed to have a thickness of 40 nm with a variation of ± 25 percent. The surface strap spacer is assumed to have a nominal thickness of 30 nm with a variation of ± 20 percent.

There has been described and illustrated a surface strap trench cell preferably for a 256 Mb DRAM. The surface strap is self-aligned to the gate polysilicon and is electrically encapsulated from the intrinsic polysilicon mandrel. The inclusion of an electrically conductive diffusion barrier prevents the deposits from the strap diffusing to the source/drain area or to the sensitive transfer device area. The cell area is 0.6*µm*² using 0.25*µm* minimum line width and is comparable to that achievable with a diffused strap. For the same cell area, the trench size and therefore the storage capacitance is larger for the surface strap layout than for the conventional diffusion strap layout.

The preferred embodiment of the invention as described above comprises an electrically conductive self-aligned surface strap including a TiN liner diffusion barrier material. However, the invention applies equally as well when the surface strap comprises an alternative electrically conductive liner diffusion barrier, such as TaN.

The polarity of the strap polysilicon can be p-type or n-type regardless of the polarity of the substrate, cell or source/drain diffusion.

While the dimensions are recited for a 256 Mb DRAM cell, it will be apparent to those skilled in the art that the principles and teachings of the present invention are applicable to other high density DRAM cells, including cells having densities greater than 256 Mb.

While there has been described and illustrated a preferred self-aligned polysilicon strap with an electrically conductive diffusion barrier such as TiN for high density DRAM cells and a preferred method of fabricating the same, it will be apparent to those skilled in the art that variations and modifications are possible without deviating from the broad principle and spirit of the present invention which shall be limited solely by the scope of the claims appended hereto.

## Claims

1. A memory cell comprising:
a semiconductor substrate;
a storage trench formed within an opening in said semiconductor substrate;
an access device having a diffusion region; and
a self-aligned strap coupling said storage trench to said diffusion region wherein said strap includes an electrically conductive liner diffusion barrier material.

2. A memory cell as set forth in claim 1,
wherein said strap is a surface strap.

3. A memory cell as set forth in claim 1 or 2,
wherein said strap extends along a horizontal surface of said substrate.

4. A memory cell as set forth in at least one of claims 1 to 3,
wherein said strap is horizontally self-aligned with said diffusion region.

5. A memory cell as set forth in at least one of claims 1 to 4,
further comprising a word line, and said strap being self-aligned with said word line.

6. A memory cell as set forth in at least one of claims 1 to 5,
wherein said diffusion region includes a gate region and said strap is self-aligned with said gate region.

7. A memory cell as set forth in at least one of claims 1 to 6,
wherein said strap further comprises polysilicon.

8. A memory cell as set forth in claim 7,
wherein said diffusion barrier material is disposed between said polysilicon and said diffusion region.

9. A memory cell as set forth in claim 7 or 8,
wherein the polarity of said polysilicon is selected to be either p-type or n-type regardless of the polarity of said substrate, said trench and said diffusion region.

10. A memory cell as set forth in at least one of claims 1 to 9,
wherein said diffusion barrier material is TiN.

11. A memory cell as set forth in at least one of claims 1 to 9,
wherein said diffusion barrier material is TaN.

12. A memory cell as set forth in at least one of claims 1 to 11,
wherein said diffusion region is a source/drain.

13. A memory cell as set forth in at least one of claims 1 to 12,
wherein said memory cell is a DRAM cell.

14. A method of fabricating a memory cell comprising the steps of:
(a) forming a storage trench, LOCUS/STI and wordline in self alignment in a semiconductor substrate;
(b) depositing a mandrel on said substrate;
(c) planarizing said mandrel;
(d) etching said mandrel to form regions to contain a strap;
(e) etching trench cap oxide on said mandrel;
(f) applying photoresist;
(g) stripping and removing said photoresist;
(h) forming an oxide spacer in said strap region;
(i) depositing a layer of an electrically conductive liner diffusion barrier material over said substrate, especially with a thickness of approximately 40 nm;
(j) depositing polysilicon into said strap region;
(k) polishing and recessing said polysilicon below said diffusion barrier material top surface;
(l) removing said diffusion barrier material layer from said substrate top surface;
(m) further recessing said polysilicon;
(n) removing a nitride layer and subsequently exposed polysilicon layer from said substrate top surface;
(o) depositing a silicon nitride cap layer;
(p) depositing a polysilicon layer over said cap layer; and
(q) etching off said cap layer.

15. A method of fabricating a memory cell
as set forth in claim 14,
further comprising instead of step (d) the steps of:
(d1) depositing a layer of nitride on said mandrel;
(d2) depositing a layer of polysilicon on said nitride layer;
(d3) depositing a layer of nitride on said polysllicon layer;
(d4) etching said layers formed in steps (d1), (d2) and (d3) to form regions to contain a strap.

16. A method of fabricating a memory cell
as set forth in claim 14 or 15,
further comprising after step (p) planarizing said polysilicon.

17. A method of fabricating a memory cell
as set forth in claim 15,
where said mandrel is permanent.

18. A method of fabricating a memory cell
as set forth in claim 15,
where said mandrel is removable.
